# EUROPEAN PATENT APPLICATION

(11) **EP 4 804 786 A1**
(43) Date of publication of application: **09.09.2026**
(21) Application number: 25200951.9
(22) Date of filing: 09.09.2025
(51) Int. Cl.: H10W 90/20, H10W 40/25, H10W 74/10, H10W 90/26

(54) **INTEGRATED CIRCUIT MODULES BONDED ALONG INTERFACE HAVING ELECTRICALLY INSULATIVE THERMALLY CONDUCTIVE LAYER**

(30) Priority: 05.03.2025 US 202519070878
(71) Applicant: GlobalFoundries U.S. Inc., Malta, NY 12020 (US)
(72) Inventor: Karumuri, Naveen, 560043 Bangalore (IN); Turuvekere, Sreenidhi, 560043 Bangalore (IN); Choppalli, Satyasuresh Vvss, 560043 Bangalore (IN); Das, Pallabi, 700037 West Bengal (IN); Restrepo, Oscar D., Malta, 12020 (US); Liu, Fangyue, 738406 Singapore (SG); Toh, Rui Tze, 738406 Singapore (SG); Swaminathan, Balaji, 560043 Bangalore (IN)
(74) Representative: Grünecker Patent- und Rechtsanwälte PartG mbB

(57) **Abstract**

Embodiments of the disclosure provide a structure with a plurality of integrated circuit (IC) modules. Each IC module of the plurality of IC modules having a device layer and a metal wiring stack thereon. The plurality of IC modules including a first IC module coupled to an inverted second IC module along a bonding interface. The bonding interface including an electrically insulative, thermally conductive layer.

## Description

### BACKGROUND

The present disclosure relates to bonding interfaces, and more specifically to bonding interfaces within a stack of integrated circuits each having a device layer and a plurality of wiring layers, and a related method.

Chip to wafer and wafer to wafer bonding has the potential to improve performance of a wide variety of technologies. Achieving a bond with sufficient bond strength and power handling capability in face-to-face bonded devices is a technical challenge. For example, improving the power handling capacity in one integrated circuit module (e.g., increasing the handling capacity for on-state operation of a stacked radio frequency (RF) switch) may be difficult due to the number of wires and/or the nature of connected components in multilayer stacks. Power handling capacity may be especially difficult in devices prone to being constrained in certain areas, e.g., stacked devices. Conventional bonding techniques do not provide sufficient thermal management to achieve desired levels of performance and/or manufacturability.

### SUMMARY

All aspects, examples and features mentioned below can be combined in any technically possible way.

An aspect of the disclosure provides a structure comprising: a plurality of integrated circuit (IC) modules each having a device layer a metal wiring stack thereon, the plurality of IC modules including: a first IC module, and a second IC module inverted over the first IC module and coupled to the first IC module along a bonding interface, wherein the bonding interface includes an electrically insulative, thermally conductive layer.

An aspect of the disclosure provides a structure comprising: a plurality of a plurality of integrated circuit (IC) modules each having a device layer and a metal wiring stack thereon, the plurality of IC modules including: a first IC module, and a second IC module inverted over the first IC module and coupled to the first IC module along a bonding interface, wherein the bonding interface includes a first electrically insulative, thermally conductive material; and a heat management stack on the plurality of IC modules, the heat management stack including: a dielectric layer, and a second thermally conductive electrically insulative layer on the dielectric layer.

An aspect of the disclosure provides a method of forming a structure, comprising: forming a plurality of integrated circuit (IC) modules each having a device layer and a metal wiring stack thereon, the plurality of IC modules including: a first IC module, and a second IC module inverted over the first IC module; coupling the plurality of IC modules along one or more bonding interfaces, wherein the bonding interfaces includes an electrically insulative, thermally conductive material.

Two or more aspects described in this disclosure, including those described in this summary section, may be combined to form implementations not specifically described herein. The details of one or more implementations are set forth in the accompanying drawings and the description below. Other features, objects and advantages will be apparent from the description and drawings, and from the claims.

### BRIEF DESCRIPTION OF THE DRAWINGS

The embodiments of this disclosure will be described in detail, with reference to the following figures, wherein like designations denote like elements, and wherein:
FIG. 1 shows a cross-sectional view of an integrated circuit stack bonded along an interface, according to embodiments of the disclosure;
FIG. 2 shows a cross-sectional view of an integrated circuit stack bonded along a bonding interface having ridges and recesses, according to embodiments of the disclosure;
FIG. 3 shows a cross-sectional view of an integrated circuit stack bonded along an interface with a heat management stack, according to embodiments of the disclosure;
FIG. 4 shows a cross-sectional view of a stack of more than two integrated circuits bonded along multiple interfaces with heat management stacks, according to embodiments of the disclosure.

It is noted that the drawings of the disclosure are not necessarily to scale. The drawings are intended to depict only typical aspects of the disclosure, and therefore should not be considered as limiting the scope of the disclosure. In the drawings, like numbering represents like elements between the drawings.

### DETAILED DESCRIPTION

In the following description, reference is made to the accompanying drawings that form a part thereof, and in which is shown by way of illustration specific illustrative embodiments in which the present teachings may be practiced. These embodiments are described in sufficient detail to enable those skilled in the art to practice the present teachings, and it is to be understood that other embodiments may be used and that changes may be made without departing from the scope of the present teachings. The following description is, therefore, merely illustrative.

It will be understood that when an element such as a layer, region, or substrate is referred to as being "on" or "over" another element, it may be directly on the other element or intervening elements may also be present. In contrast, when an element is referred to as being "directly on" or "directly over" another element, there may be no intervening elements present. It will also be understood that when an element is referred to as being "connected" or "coupled" to another element, it may be directly connected or coupled to the other element or intervening elements may be present. In contrast, when an element is referred to as being "directly connected" or "directly coupled" to another element, there are no intervening elements present.

Reference in the specification to "one embodiment" or "an embodiment" of the present disclosure, as well as other variations thereof, means that a particular feature, structure, characteristic, and so forth described in connection with the embodiment is included in at least one embodiment of the present disclosure. Thus, the phrases "in one embodiment" or "in an embodiment," as well as any other variations appearing in various places throughout the specification are not necessarily all referring to the same embodiment. It is to be appreciated that the use of any of the following "/," "and/or," and "at least one of," for example, in the cases of "A/B," "A and/or B" and "at least one of A and B," is intended to encompass the selection of the first listed option (A) only, or the selection of the second listed option (B) only, or the selection of both options (A and B). As a further example, in the cases of "A, B, and/or C" and "at least one of A, B, and C," such phrasing is intended to encompass the first listed option (A) only, or the selection of the second listed option (B) only, or the selection of the third listed option (C) only, or the selection of the first and the second listed options (A and B), or the selection of the first and third listed options (A and C) only, or the selection of the second and third listed options (B and C) only, or the selection of all three options (A and B and C). This may be extended, as readily apparent by one of ordinary skill in the art, for as many items listed.

Embodiments of the disclosure include a structure having an integrated circuit (IC) stack bonded along an interface and a related method. The structure includes integrated circuit modules to be coupled face to face and a bonding interface having an electrically insulative, thermally conductive layer, e.g., diamond, aluminum oxide, or diamond-like carbon (herein referred to as DLC). The use of structure with IC modules coupled by a bonding interface provides many benefits for the bonded IC stack. For example, the bonded interface provides the IC stack the ability to have more than two IC modules bonded together (e.g., four or more) to create a "super-chip." The structure and composition of the bonding interface benefits thermal management of the structure and therefore also improves power handling capabilities during operation. In some embodiments, the structure may also include a heat management stack, a combination of dielectric and electrically insulative, thermally conductive layers, further benefiting thermal management.

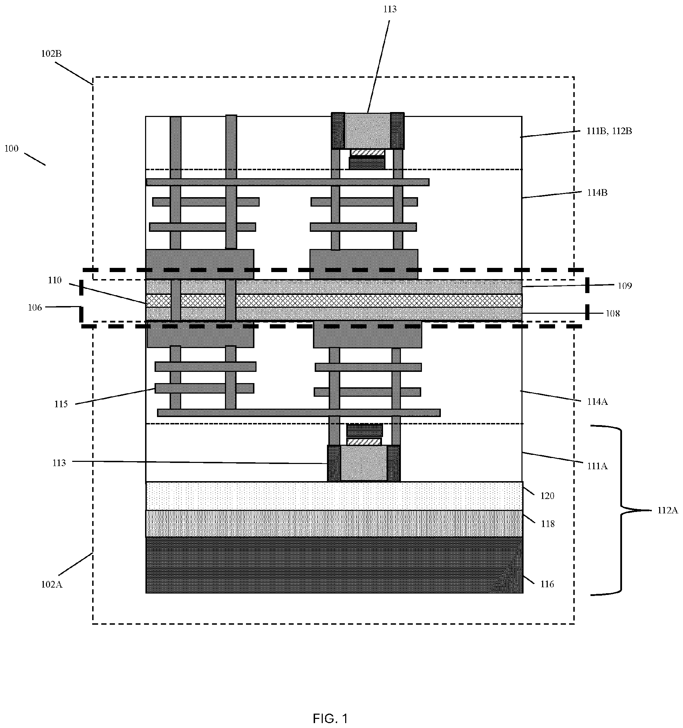

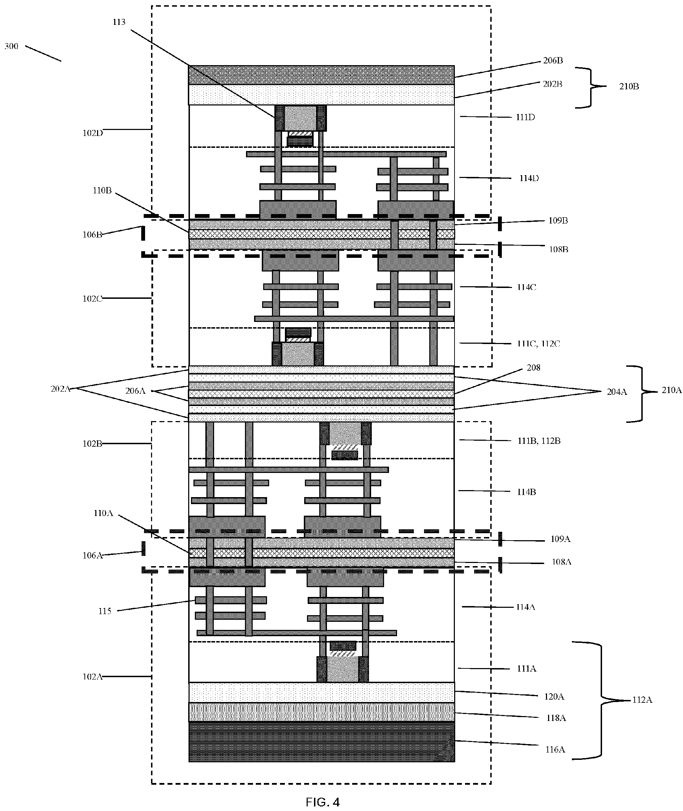

FIG. 1 shows a cross-sectional view of structure 100 having a plurality of IC modules 102, specifically, first IC module 102A and second IC module 102B, coupled along bonding interface 106. In some embodiments the IC modules 102 may include device layer 112 and metal wiring stack 114. The plurality of IC modules 102 may be formed independently or together. Further structure 100 may integrate heterogenous or homogeneous modules into the structure (i.e., their designs may be identical or distinct). Further, there may be two or more IC modules 102 in structure 100, with each IC module 102 being coupled to at least one other IC module 102 along a bonding interface 106. For example, as shown in FIG. 4, structure 100 may have four IC modules 102: a first IC module 102A; a second IC module 102B on first IC module 102A; a third IC module 102C on second IC module 102B; and a fourth IC module 102D on third IC module 102C. In some embodiments, IC modules 102 may be inverted with respect to another corresponding IC module 102. For example, IC modules 102 may be numbered by successive non-zero integers (1, 2, 3, 4... N), IC modules 102 corresponding to even numbers are inverted in comparison to IC modules 102 having an odd number designation. In some embodiments, the plurality of IC modules 102 are even in number and having the last IC module (N) 102 in an inverted position.

IC modules 102 contain device layer 112, which may include a semiconductor substrate 116, a polycrystalline layer 118, an additional insulator layer 120, and a semiconductor region 111. For example, a structure may contain four IC modules 102, with the first and fourth IC modules having a device layer may include a semiconductor substrate 116, a polycrystalline layer 118, an additional insulator layer 120, and a semiconductor region 111. In said example second and third IC modules include only a semiconductor region 111.

As shown in FIG.1, structure 100 may include an IC module 102, or multiple IC modules 102 (FIG. 4) having semiconductor substrate 116 in device layer 112. Semiconductor substrate 116 may include but is not limited to silicon on insulator (SOI), silicon on sapphire (SoS), silicon, germanium, silicon germanium, silicon carbide, and those consisting essentially of one or more III-V compound semiconductors having a composition defined by the formula Al_{X1}Ga_{X2}In_{X3}As_{Y1}P_{Y2}N_{Y3}Sb_{Y4}, where X1, X2, X3, Y1, Y2, Y3, and Y4 represent relative proportions, each greater than or equal to zero and X1+X2+X3+Y1+Y2+Y3+Y4=1 (1 being the total relative mole quantity). Other substrates are also possible. Furthermore, a portion or entire semiconductor substrate 116 may be strained.

Device layer 112 of IC modules 102 may also include a polycrystalline layer 118 formed on semiconductor substrate 116. In some embodiments polycrystalline layer 118 is below additional insulator layer 120. Polycrystalline layer 118 may be formed by introducing ions of a noble gas into a semiconductor layer on semiconductor substrate 116 and/or an upper portion thereof and annealing the semiconductor material with the noble gas ions therein. In some embodiments, polycrystalline layer 118 may have a semiconductor composition and thus can be used as a seed layer for deposition and epitaxial growth of other semiconductor materials of varying conductivity.

Device layer 112 of IC modules 102 may include embedded elements for electrically separating active materials formed thereon from other regions and/or materials from semiconductor substrate 116 and/or polycrystalline layer 118. An additional insulator layer 120 may be formed over semiconductor substrate 116 and polycrystalline layer 118, e.g., by forming a layer of dielectric material (e.g., oxide or nitride insulative material), converting silicon material within semiconductor substrate 116 into a higher-resistive material such as polycrystalline or amorphous silicon (poly-Si), or other techniques. Additional insulator layer 120 may extend horizontally throughout IC modules 102, and/or may be formed selectively under locations where active materials are formed, examples of which are discussed elsewhere herein. In further implementations, additional insulator layer 120 may include oxygen doping to form a dielectric insulator or a buried oxide ("BOX") layer over semiconductor substrate 116 and polycrystalline layer 118 to electrically isolate semiconductor region 111 from semiconductor substrate 116.

Additional insulator layer 120 may include other elements or molecules such as Ge, N, or Si. Additional insulator layer 120 may be formed of any currently-known or later developed substance for providing electrical insulation, and as examples may include: silicon nitride (Si₃N₄), silicon oxide (SiO₂), fluorinated SiO₂ (FSG), hydrogenated silicon oxycarbide (SiCOH), porous SiCOH, boro-phospho-silicate glass (BPSG), silsesquioxanes, carbon (C) doped oxides (i.e., organosilicates) that include atoms of silicon (Si), carbon (C), oxygen (O), and/or hydrogen (H), thermosetting polyarylene ethers, a spin-on silicon-carbon containing polymer material, near frictionless carbon (NFC), or layers thereof. However embodied, additional insulator layer 120 may be sized as narrow as possible to provide better interaction with overlying semiconductor materials (e.g., device layer 112, metal wiring stack 114 and components formed thereon or therefrom). Some portions (not shown) of semiconductor substrate 116 may not have additional insulator layer 120 thereover, and/or multiple layers of additional insulator layer 120 may be formed on semiconductor substrate 116 to varying thicknesses. Additionally, various conductive particles ("dopants") may be introduced into semiconductor substrate 116 via a process known as "pre-doping" of semiconductor substrate 116.

Further processing may include forming a semiconductor region 111 by deposition or using any known or later developed semiconductor fabrication process. Semiconductor region 111 may include dielectric or semiconductor material placed between metal interconnects, such as vias, and active devices 113. In some embodiments active devices 113 in semiconductor region 111 may be isolated by trench isolation techniques (not shown). For example, active device 113 may be a field-effect transistor (FET) surrounded by shallow trench isolation (STI) regions. Semiconductor region 111 may include or may be adjacent a barrier layer (not shown) in order to provide an additional protective barrier between the semiconductor or dielectric materials and the metal interconnects as well as the metal wiring stack 114, and/or to function as an "etch stop layer" for independent processing of certain layers.

One or more active devices 113 may be formed in each IC module 102. In some embodiments, active devices 113 or portions thereof are formed on additional insulator layer 120. Each active device 113 may be defined within the combination of semiconductor and dielectric layers within the semiconductor region 111 and can include any known or later developed semiconductor device (RF switch, power amplifier, transistor, gate, diode, etc.).

Each IC module 102 may include a metal wiring stack 114 in contact with the device layer 112 and bonding interface 106. Within metal wiring stack 114 are dielectric layers for the various back-end of line (BEOL) metal and via levels (e.g., M1-V1, M2-V2, and so on). These additional dielectric layers can include, for example, a stack of relatively thick dielectric layers (e.g., thick inter-layer dielectric (ILD) material layers) for each metal level and each via level (e.g., in the case of single damascene processing) or for each combined metal and via level (e.g., in the case of single damascene processing). The additional dielectric layers can also include relatively thin dielectric layers (e.g., etch stop layers) therebetween. In some embodiments, the metal interconnects, such as metal levels and vias, comprise a set of metal lines 115. Metal lines 115 may include any currently known or later developed conductive material configured for use in an electrical contact, e.g., tungsten (W), copper (Cu), aluminum (Al), gold (Au), etc. Metal lines 115 may additionally include refractory metal liners (not shown) positioned alongside semiconductor region 111 to prevent electromigration degradation, shorting to other components, etc. In some embodiments, metal lines 115 contacts active device 113 in semiconductor region 111 and can contact the bonding interface 106, as described herein. For example, active device 113 may be an RF switch electrically coupled to set of metal lines 115 within metal wiring stack 114. In said example, set of metal lines 115 contacts first electrically insulative, thermally conductive layer 108 or additional electrically insulative, thermally conductive layer 109, as described herein.

As shown in FIG. 1-4, IC modules 102 may be coupled along a bonding interface 106. Bonding interface 106 may include first electrically insulative, thermally conductive layer 108, an additional electrically insulative, thermally conductive layer 109 and an insulator layer 110. First electrically insulative, thermally conductive layer 108 may be composed of any material, now known or later developed, that effectively transfers heat (i.e., exhibits high thermal conductivity) while also substantially preventing the flow of electricity (i.e., exhibits high electrical resistance) e.g., diamond, DLC, aluminum oxide, and/or similar materials. First electrically insulative, thermally conductive layer 108 may connect to metal wiring stack 114 of at least one IC module 102 for managing heat dissipation and electrically isolating an IC module 102 from other IC modules 102 of the plurality of IC modules each 102. For example, as shown in FIG. 1, active device 113 may be an RF switch electrically connected to metal wiring stack 114. Metal wiring stack 114 may be connected to electrically insulative, thermally conductive layer 109 for transferring heat generated by active device 113 and electrically isolating first IC module 102A from other IC modules 102. Further, first electrically insulative, thermally conductive layer 108 may vary widely between implementations. In some embodiments, first electrically insulative, thermally conductive layer 108 may be shaped based on IC module 102 to ensure thermal conductivity. For example, as shown in FIG. 1, first electrically insulative, thermally conductive layer 108 may have substantially planar surfaces such that metal wiring stack 114 contacts a side of first electrically insulative, thermally conductive layer 108 at one or more points.

As shown in FIG. 1-4, bonding interface 106 may also include an additional electrically insulative, thermally conductive layer 109 and an insulator layer 110. Insulator layer 110 electrically isolates the IC modules 102 from each other and can bond first electrically insulative, thermally conductive layer 108 to additional electrically insulative, thermally conductive layer 109. Insulator layer 110 may be formed of any currently known or later developed substance for providing electrical insulation, and as examples may include: silicon nitride, aluminum oxide, silicon dioxide, magnesium oxide and titanium dioxide. In some embodiments insulator layer 110 is one layer or a plurality of layers. However embodied, insulator layer 110 may be sized to provide better interaction with the surrounding electrically insulative, thermally conductive layers 108, 109. In some embodiments insulator layer 110 is on first electrically insulative, thermally conductive layer 108 and additional electrically insulative, thermally conductive layer 109 is on the insulator layer 110, such that insulator layer 110 is between the first electrically insulative, thermally conductive layer 108 and the additional electrically insulative, thermally conductive layer 109.

Bonding interface 106 may also include an additional electrically insulative, thermally conductive layer 109. Additional electrically insulative, thermally conductive layer 109 may be composed of the same material as first electrically insulative, thermally conductive layer 108, and/or any other example compositions discussed herein. Further, additional electrically insulative, thermally conductive layer 109 may be the same size and shape as first electrically insulative, thermally conductive layer 108. According to some embodiments additional electrically insulative, thermally conductive layer 109 may be on insulator layer 110 and contact a metal wiring stack 114 of an IC module 102, of the plurality of IC modules. In some embodiments, additional electrically insulative, thermally conductive layer may also be shaped based on IC module 102 to ensure thermal conductivity. For example, as shown in FIG. 1, additional electrically insulative, thermally conductive layer 109 and first electrically insulative, thermally conductive layer 108 may both be connected to respective homogeneous IC modules 102A, 102B and the shape of electrically insulative, thermally conductive layers 108, 109 are symmetrical about a horizontal axis extending through insulator layer 110.

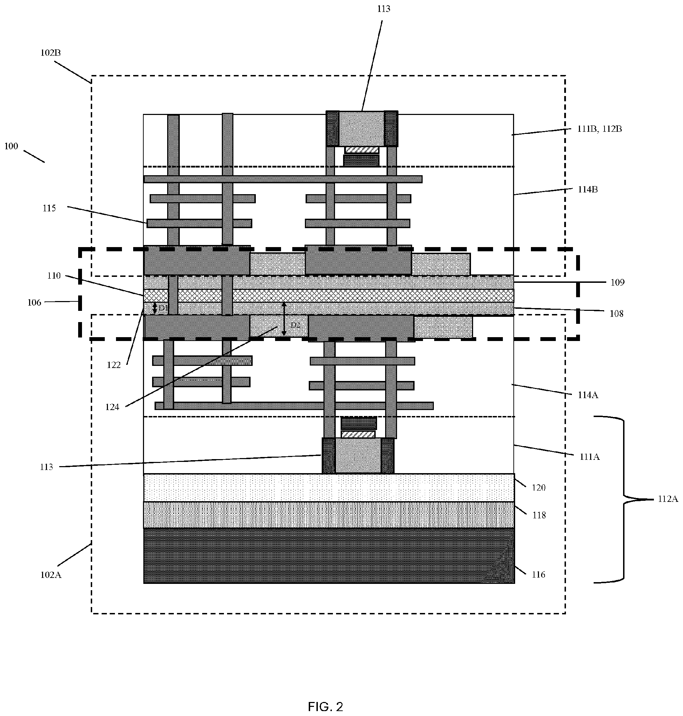

As shown in FIG. 2, first electrically insulative, thermally conductive layer 108, and additional electrically insulative, thermally conductive layer 109 may vary widely between implementations. As discussed, first electrically insulative, thermally conductive layer 108, and/or additional electrically insulative, thermally conductive layer 109 may be formed based on the structure of a respective IC module 102. In some embodiments, the size and shape of electrically insulative, thermally conductive layers 108, 109 may be based on metal wiring stack 114 to ensure thermal conductivity between both IC modules 102 and bonding interface 106, while also electrically isolating each IC module 102. In some embodiments, electrically insulative, thermally conductive layers 108, 109 may contain one or more recesses 122 and ridges 124. Recesses 122 are localized depressions in electrically insulative, thermally conductive layers 108, 109 creating regions having reduced thickness. Recesses 122 may have a first depth relative to insulator layer 110. Ridges 124 are localized regions in electrically insulative, thermally conductive layers 108, 109 creating regions having increased thickness. Ridges may have a second depth, relative to insulator layer 110, where the second depth is greater than that of the first depth. Further, in some embodiments recesses 122 and ridges 124 may correspond to a portion of set of metal lines 115, of metal wiring stack 114, such that a portion set of metal lines 115 contacts electrically insulative, thermally conductive layers 108, 109 on two or more sides. For example, as shown in FIGS. 2-3, electrically insulative, thermally conductive layers 108, 109 may be configured to fit a portion of set of metal lines 115 within recesses 122 and contacting a side of ridges 124.

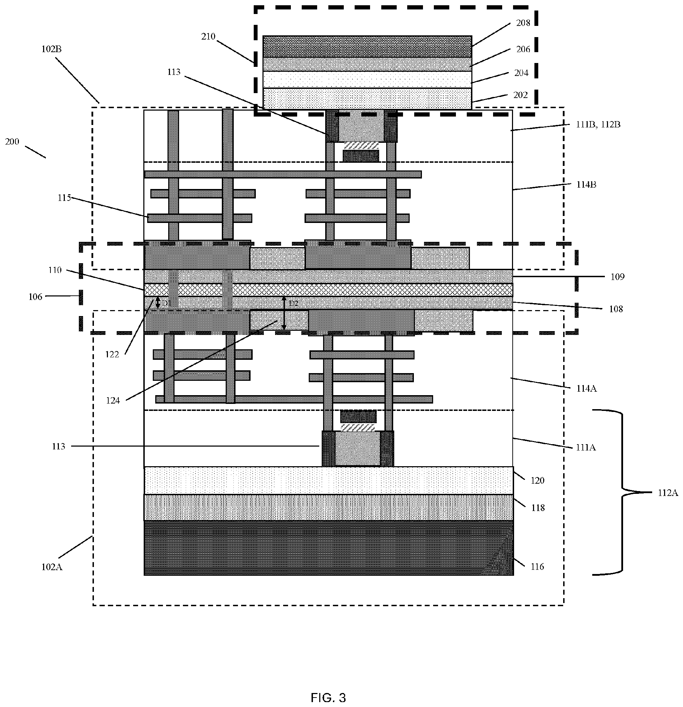

As shown in FIG. 3, structure 200 may optionally include forming heat management stack 210 on IC modules 102. In some embodiments heat management stack 210 may include dielectric layers 202, 204, a second electrically insulative, thermally conductive layer 206 and passivation layer 208. Heat management stack 210 may extend horizontally over portions of IC module 102 and/or may be located based on locations where active materials are formed, examples of which are discussed elsewhere herein. Further, heat management stack 210 may thermally connect to an IC module's 102 device layer in order to dissipate heat and electrically isolate IC module 102. For example, as shown in FIG. 3, heat management stack 210 may be in thermal communication with semiconductor region 111 of the topmost IC module 102B. Specifically, heat management stack 210 may be in thermal communication with active device 113 e.g., RF switch, in semiconductor region 111.

Forming heat management stack 210 may include depositing one or more dielectric layers 202, 204, over a respective IC module 102. Dielectric layers 202, 204 may be composed of the same material as insulator layer 110, additional insulator layer 120, or may include any other material known or later developed capable of electrically isolating IC module 102. In some embodiments, dielectric layer 202 may be the same material as insulator layer 110 e.g., silicon dioxide. The dielectric layers 202, 204 may also vary in material from layer to layer or contain the same material. For example, first dielectric layer 202 may be silicon dioxide deposited on IC module 102 and second dielectric layer 204 may be silicon nitride deposited on first dielectric layer 202.

Forming heat management stack 210 may include depositing a second electrically insulative, thermally conductive layer 206. Second electrically insulative, thermally conductive layer 206 may be composed of the same material as first and additional electrically insulative, thermally conductive layer 108, 109 e.g., diamond, aluminum oxide, or DLC. Further, second electrically insulative, thermally conductive layer extends horizontally over dielectric layers 202, 204 but may vary in shape depending on the IC module 102 there below.

As shown in FIG. 3, heat management stack 210 may also include a passivation layer 208. Passivation layer 208 may be composed of the same material as insulator layer 110, additional insulator layer 120, or dielectric layers 202, 204 e.g., silicon dioxide, silicon nitride, etc. Passivation layer 208 may be formed over second electrically insulative, thermally conductive layer 206 to protect heat management stack 210 and IC module 102 from corrosion, oxidation, or other forms of degradation.

As discussed, some embodiments contain two or more IC modules, which are known colloquially as "super-chips." As shown in FIG. 4, some embodiments of super-chips include heat management stack 210. In some embodiments, heat management stack 210 may contact more than one device layer 112 at a time. For example, as shown in FIG. 4, heat management stack 210A may contact device layer 112B of second IC module 102B and contact device layer 112C of third IC module 102C. As previously described, heat management stack 210 may include a plurality of dielectric layers 202, 204, a second electrically insulative, thermally conductive layer 206 and passivation layer 208.

These layers may differ in arrangement depending on the configuration of IC modules 102 in structure 300. For example, as shown in FIG. 4, heat management stack 210 may include a first dielectric layer 202A, a second dielectric layer 204A on first dielectric layer 202A, second electrically insulative, thermally conductive layer 206A on second dielectric layer 204A, passivation layer 208 on electrically insulative, thermally conductive layer 206A, an additional second electrically insulative, thermally conductive layer 206A on passivation layer 208, an additional second dielectric layer 204A on additional second electrically insulative, thermally conductive layer 206A, and an additional first dielectric layer 202A on additional second dielectric layer 204A. In said example, first dielectric layers 202A contact device layer 112 of the second and third IC module 102B, 102C, respectively.

Further, in some embodiments, structure 300 may include a plurality of heat management stacks 210 in order to dissipate heat and electrically isolate IC modules 102. Heat management stacks 210 may differ in composition or may be homogeneous. In an embodiment, shown in FIG. 4, heat management stack 210A couples second IC module 102B to third IC module 102C and includes multiple dielectric layers 202A, 204A, a second electrically insulative, thermally conductive layer 206A and a passivation layer 208. In this example, second heat management stack 210B is formed over fourth IC module 102D and includes a first dielectric layer 202B and a second electrically insulative, thermally conductive layer 206B.

As described, IC modules 102 may be arranged in a variety of arrangements. In an embodiment shown in FIG. 4, structure 300 contains four IC modules (102A, 102B, 102C, 102D) stacked on each other, each IC module 102 including device layer 112 and metal wiring stack 114. In some embodiments the IC modules are formed as follows: first bonding interface 106A couples first IC module 102A to second IC module 102B; heat management stack 210A couples second IC module 102B to third IC module 102C; second bonding interface 106B couples third IC module 102C to fourth IC module 102D; second heat management stack 210B is over fourth IC module 102D, such that each IC module 102 is electrically isolated and in thermal contact with a bonding interface.

Each device layer 112 in IC modules 102 may include a semiconductor substrate 116, a polycrystalline layer 118, an additional insulator layer 120, and semiconductor region 111. As such, each IC module 102 may be homogeneous or heterogeneous in respect to other IC modules. For example, as shown in structure 330 in FIG. 4: First IC module 102 includes a device layer 112A having a semiconductor substrate 116A, a polycrystalline layer 118A on semiconductor substrate 116A, an additional insulator layer 120A on polycrystalline layer 118A, and semiconductor region 111A on an additional insulator layer 120A while second, third, and fourth IC modules 102B, 102C, 102D include a semiconductor region 111B, 111C, 111D. semiconductor regions 111A, 111B, 111C, 111D may also contain active device 113 e.g. RF switch, power amplifier, transistor, gate, diode. etc. Active device 113 may be the same or different across multiple IC modules 102. For example, a structure 300 having four IC modules 102 may have four semiconductor regions 111, each having an RF switch electrically coupled to metal wiring stack 114.

The present disclosure provides various technical and commercial advantages, examples of which are discussed herein. In radio frequency (RF) applications, embodiments of structure 100 may be implemented at a lower cost and with improved power handling, due to the stacking of IC modules 102 and heat management, as described in non-limiting examples of the disclosure. Structure 100 may also provide sufficient electrical isolation for IC modules 102 from other IC modules. In addition, structure 100 is suitable for heterogeneous and homogeneous IC module 102 integration and may be particularly suitable for structures formed using flip chip manufacturing techniques.

The method and structure as described above is used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher-level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a center processor.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof. "Optional" or "optionally" means that the subsequently described event or circumstance may or may not occur, and that the description includes instances where the event occurs and instances where it does not.

Approximating language, as used herein throughout the specification and claims, may be applied to modify any quantitative representation that could permissibly vary without resulting in a change in the basic function to which it is related. Accordingly, a value modified by a term or terms, such as "about," "approximately," and "substantially," are not to be limited to the precise value specified. In at least some instances, the approximating language may correspond to the precision of an instrument for measuring the value. Here and throughout the specification and claims, range limitations may be combined and/or interchanged, such ranges are identified and include all the sub-ranges contained therein unless context or language indicates otherwise. "Approximately" as applied to a particular value of a range applies to both values, and unless otherwise dependent on the precision of the instrument measuring the value, may indicate +/-10% of the stated value(s).

The corresponding structures, materials, acts, and equivalents of all means or step plus function elements in the claims below are intended to include any structure, material, or act for performing the function in combination with other claimed elements as specifically claimed. The description of the present disclosure has been presented for purposes of illustration and description but is not intended to be exhaustive or limited to the disclosure in the form disclosed. Many modifications and variations will be apparent to those of ordinary skill in the art without departing from the scope and spirit of the disclosure. The embodiment was chosen and described in order to best explain the principles of the disclosure and the practical application, and to enable others of ordinary skill in the art to understand the disclosure for various embodiments with various modifications as are suited to the particular use contemplated.

In summary, embodiments of the disclosure provide a structure with a plurality of integrated circuit (IC) modules. Each IC module of the plurality of IC modules having a device layer and a metal wiring stack thereon. The plurality of IC modules including a first IC module coupled to an inverted second IC module along a bonding interface. The bonding interface including an electrically insulative, thermally conductive layer.

The following embodiments are explicitly disclosed.

### Embodiment 1:

A structure comprising:
a plurality of integrated circuit (IC) modules each having a device layer and a metal wiring stack thereon, the plurality of IC modules including:
   a first IC module, and
   a second IC module inverted over the first IC module and coupled to the first IC module along a bonding interface, wherein the bonding interface includes an electrically insulative, thermally conductive layer.

### Embodiment 2:

The structure of embodiment 1, wherein the bonding interface includes;
an insulator layer on the electrically insulative, thermally conductive layer; and
an additional electrically insulative, thermally conductive layer on the insulator layer, wherein the insulator layer is between the electrically insulative, thermally conductive layer and the additional electrically insulative, thermally conductive layer.

### Embodiment 3:

The structure of embodiment 2, wherein the electrically insulative, thermally conductive layer includes a recess having a first depth, relative to the insulator layer, and a ridge having a second depth, relative to the bonding interface, that is greater than the first depth.

### Embodiment 4:

The structure of embodiment 3, further comprising an active device within the device layer of one of the plurality of IC modules, wherein the active device is electrically coupled to a set of metal lines in the metal wiring stack thereon, wherein the electrically insulative, thermally conductive layer additionally contacts the set of metal lines.

### Embodiment 5:

The structure of embodiment 4, wherein one of the set of metal lines is within the recess of the electrically insulative, thermally conductive layer.

### Embodiment 6:

The structure of one of embodiments 1 to 5, wherein the electrically insulative, thermally conductive layer includes diamond, diamond-like carbon (DLC), or aluminum oxide.

### Embodiment 7:

A structure comprising:
a plurality of a plurality of integrated circuit (IC) modules each having a device layer and a metal wiring stack thereon, the plurality of IC modules including:
   a first IC module, and
   a second IC module inverted over the first IC module and coupled to the first IC module along a bonding interface, wherein the bonding interface includes a first electrically insulative, thermally conductive material; and
a heat management stack on the plurality of IC modules, the heat management stack including:
   a dielectric layer, and
   a second thermally conductive electrically insulative layer on the dielectric layer.

In some illustrative examples of embodiment 7, the structure of embodiment 7 may be related to one of embodiments 1 to 6 in that there is provided in these illustrative examples of embodiment 7:
The structure of one of embodiments 1 to 6, wherein the bonding interface includes the electrically insulative, thermally conductive material as a first electrically insulative, thermally conductive material, and wherein the structure further comprises:
a heat management stack on the plurality of IC modules,
wherein the heat management stack includes:
   a dielectric layer, and
a second thermally conductive electrically insulative layer on the dielectric layer.

In these illustrative examples of embodiment 7, the structure of embodiment 7 may be considered as being based on at least one of embodiments 1 to 6.

### Embodiment 8:

The structure of embodiment 7, wherein the bonding interface includes;
an insulator layer on the first electrically insulative, thermally conductive layer; and
an additional electrically insulative, thermally conductive layer on the insulator layer, wherein the insulator layer is between the first electrically insulative, thermally conductive layer and the additional electrically insulative, thermally conductive layer.

### Embodiment 9:

The structure of embodiment 8, wherein the first electrically insulative, thermally conductive layer includes a recess having a first depth, relative to the insulator layer, and a ridge having a second depth, relative to the insulator layer, that is greater than the first depth.

### Embodiment 10:

The structure of embodiment 9, further comprising an active device within the device layer of one of the plurality of IC modules, wherein the active device is electrically coupled to a set of metal lines in the respective metal wiring stack thereon, wherein the electrically insulative, thermally conductive layer additionally contacts the set of metal lines.

### Embodiment 11:

The structure of embodiment 10, wherein one of the set of metal lines is within the recess of the electrically insulative, thermally conductive layer.

### Embodiment 12:

The structure of embodiment 10 or 11, wherein the active device contacts the heat management stack.

### Embodiment 13:

The structure of one of embodiments 7 to 12, wherein the dielectric layer includes:
a first dielectric layer; and
a second dielectric layer on the first dielectric layer, wherein the first dielectric layer and the second dielectric layer have different compositions.

### Embodiment 14:

The structure of one of embodiments 7 to 13, wherein the first electrically insulative, thermally conductive layer includes diamond, diamond-like carbon (DLC), or aluminum oxide.

### Embodiment 15:

A method of forming a structure, comprising:
forming a plurality of integrated circuit (IC) modules each having a device layer and a metal wiring stack thereon, the plurality of IC modules including:
   a first IC module, and
   a second IC module inverted over the first IC module; and
coupling the plurality of IC modules along a bonding interface, wherein the bonding interface includes an electrically insulative, thermally conductive material.

### Embodiment 16:

The method of embodiment 15, wherein the bonding interface includes;
an insulator layer on the electrically insulative, thermally conductive layer; and
an additional electrically insulative, thermally conductive layer on the insulator layer, wherein the insulator layer is between the electrically insulative, thermally conductive layer and the additional electrically insulative, thermally conductive layer.

### Embodiment 17:

The method of embodiment 16, wherein the electrically insulative, thermally conductive layer includes a recess having a first depth, relative to the insulator layer, and a ridge having a second depth, relative to the insulator layer, that is greater than the first depth.

### Embodiment 18:

The method of embodiment 17, further comprising an active device within the device layer of one of the plurality of IC modules, wherein the active device is electrically coupled to a set of metal lines in the metal wiring stack thereon, wherein the electrically insulative, thermally conductive layer additionally contacts the set of metal lines.

### Embodiment 19:

The method of embodiment 18, further comprising:
forming a heat management stack on the plurality of IC modules, the heat management stack including:
a dielectric layer, and
a second thermally conductive electrically insulative layer on the dielectric layer.

### Embodiment 20:

The method of one of embodiments 15 to 19, wherein the electrically insulative, thermally conductive layer includes diamond, diamond-like carbon (DLC), or aluminum oxide.

### Embodiment 21:

The method of one of embodiments 15 to 20, wherein the structure of one of embodiments 1 to 14 is formed. That is, the structure formed in one of embodiments 15 to 20 corresponds to the structure of one of embodiments 1 to 14, structural features of embodiments 1 to 14 being formed in according method steps in the method of one of embodiments 15 to 20.

## Claims

1. A structure comprising:
a plurality of integrated circuit (IC) modules each having a device layer and a metal wiring stack thereon, the plurality of IC modules including:
a first IC module, and
a second IC module inverted over the first IC module and coupled to the first IC module along a bonding interface, wherein the bonding interface includes an electrically insulative, thermally conductive layer.

2. The structure of claim 1, wherein the bonding interface includes;
an insulator layer on the electrically insulative, thermally conductive layer; and
an additional electrically insulative, thermally conductive layer on the insulator layer, wherein the insulator layer is between the electrically insulative, thermally conductive layer and the additional electrically insulative, thermally conductive layer.

3. The structure of claim 2, wherein the electrically insulative, thermally conductive layer includes a recess having a first depth, relative to the insulator layer, and a ridge having a second depth, relative to the bonding interface, that is greater than the first depth.

4. The structure of claim 3, further comprising an active device within the device layer of one of the plurality of IC modules, wherein the active device is electrically coupled to a set of metal lines in the metal wiring stack thereon, wherein the electrically insulative, thermally conductive layer additionally contacts the set of metal lines.

5. The structure of claim 4, wherein one of the set of metal lines is within the recess of the electrically insulative, thermally conductive layer.

6. The structure of one of claims 1 to 5, wherein the electrically insulative, thermally conductive layer includes diamond, diamond-like carbon (DLC), or aluminum oxide.

7. The structure of one of claims 1 to 6, wherein the bonding interface includes the electrically insulative, thermally conductive material as a first electrically insulative, thermally conductive material, and wherein the structure further comprises:
a heat management stack on the plurality of IC modules,
wherein the heat management stack includes:
a dielectric layer, and
a second thermally conductive electrically insulative layer on the dielectric layer.

8. The structure of claim 7, wherein the dielectric layer includes:
a first dielectric layer; and
a second dielectric layer on the first dielectric layer, wherein the first dielectric layer and the second dielectric layer have different compositions.

9. The structure of claim 7 or 8 in combination with claim 4, wherein the active device contacts the heat management stack.

10. A method of forming a structure, comprising:
forming a plurality of integrated circuit (IC) modules each having a device layer and a metal wiring stack thereon, the plurality of IC modules including:
a first IC module, and
a second IC module inverted over the first IC module; and
coupling the plurality of IC modules along a bonding interface, wherein the bonding interface includes an electrically insulative, thermally conductive material.

11. The method of claim 10, wherein the bonding interface includes;
an insulator layer on the electrically insulative, thermally conductive layer; and
an additional electrically insulative, thermally conductive layer on the insulator layer, wherein the insulator layer is between the electrically insulative, thermally conductive layer and the additional electrically insulative, thermally conductive layer.

12. The method of claim 11, wherein the electrically insulative, thermally conductive layer includes a recess having a first depth, relative to the insulator layer, and a ridge having a second depth, relative to the insulator layer, that is greater than the first depth.

13. The method of claim 12, further comprising an active device within the device layer of one of the plurality of IC modules, wherein the active device is electrically coupled to a set of metal lines in the metal wiring stack thereon, wherein the electrically insulative, thermally conductive layer additionally contacts the set of metal lines.

14. The method of claim 13, further comprising:
forming a heat management stack on the plurality of IC modules, the heat management stack including:
a dielectric layer, and
a second thermally conductive electrically insulative layer on the dielectric layer.

15. The method of one of claims 10 to 15, wherein the electrically insulative, thermally conductive layer includes diamond, diamond-like carbon (DLC), or aluminum oxide.
